# EUROPEAN PATENT APPLICATION

(11) **EP 4 518 127 A1**
(43) Date of publication of application: **05.03.2025**
(21) Application number: 22944702.4
(22) Date of filing: 27.12.2022
(51) Int. Cl.: H02M 3/156

(54) **NON-ISOLATED DCDC CONVERTER, POWER SUPPLY, AND COMMUNICATION DEVICE**

(30) Priority: 30.05.2022 CN 202210600686
(71) Applicant: Huawei Technologies Co., Ltd., Shenzhen, Guangdong 518129 (CN)
(72) Inventor: TAN, Wei, Shenzhen, Guangdong 518129 (CN); YANG, Heqian, Shenzhen, Guangdong 518129 (CN)
(74) Representative: Goddar, Heinz J.
(86) International application number: PCT/CN2022/142280
(87) International publication number: WO 2023/231401

(57) **Abstract**

This application discloses a non-isolated DC/DC converter, a power supply, and a communication device. The non-isolated DC/DC converter includes a magnetic material, a switching transistor, and a capacitor, where the switching transistor and the capacitor form a charging and discharging loop of the non-isolated DC/DC converter; the magnetic material is located inside a printed circuit board PCB of the non-isolated DC/DC converter; the magnetic material is located in the charging and discharging loop of the non-isolated DC/DC converter; and the magnetic material provides a magnetic circuit for the charging and discharging loop of the non-isolated DC/DC converter. To reduce a loss caused by an inductor, a discrete inductor is no longer disposed in the non-isolated DC/DC converter provided in this application; instead, only a magnetic material is disposed inside the PCB, so that a loop between the magnetic material and another device forms a magnetic circuit, to provide a magnetic flux, and implement a function of the inductor. In this way, inductor disposition is reduced. Because there is no discrete inductor, power consumption caused by the inductor is reduced, so that efficiency of the entire non-isolated DC/DC converter can be improved.

## Description

This application claims priority to Chinese Patent Application No. 202210600686.2, filed with the China National Intellectual Property Administration on May 30, 2022 and entitled "NON-ISOLATED DC/DC CONVERTER, POWER SUPPLY, AND COMMUNICATION DEVICE", which is incorporated herein by reference in its entirety.

### TECHNICAL FIELD

This application relates to the field of power electronics technologies, and in particular, to a non-isolated DC/DC converter, a power supply, and a communication device.

### BACKGROUND

Currently, a power supply module of a communication device has an increasingly high requirement on power density, and the power density may be increased by increasing a switching frequency of a switching transistor in a switching power supply. However, a higher switching frequency indicates a larger loss of a converter and lower efficiency of the power supply module.

Generally, the switching power supply includes an isolated switching power supply and a non-isolated switching power supply. To reduce a size of the communication device, currently, a non-isolated DC/DC converter is used at a last level of board-level power supply of the communication device, where an inductor is used as a main magnetic element of a non-isolated direct current/direct current (DCDC, Direct Current) converter. The inductor is mainly presented in a form of planar conductor, for example, a printed circuit board (PCB, Printed Circuit Board) copper foil or a tape casting conductor.

However, the inductor has a loss in a working process, and a longer length of the inductor indicates a larger loss. Therefore, to reduce the loss, a quantity of turns of the inductor may be reduced. However, there is at least one turn of the inductor, and the at least one turn of the inductor cannot be further reduced.

### SUMMARY

To resolve the foregoing technical problem, this application provides a non-isolated DC/DC converter, a power supply, and a communication device, to reduce a loss of an inductor and improve efficiency of the non-isolated DC/DC converter.

This application provides a non-isolated DC/DC converter, including a magnetic material, a switching transistor, and a capacitor. The switching transistor and the capacitor form a charging and discharging loop of the non-isolated DC/DC converter; the magnetic material is located inside a printed circuit board PCB of the non-isolated DC/DC converter; the magnetic material is located in the charging and discharging loop of the non-isolated DC/DC converter; and a magnetic core material provides a magnetic circuit for the charging and discharging loop of the non-isolated DC/DC converter. A specific type of the non-isolated DC/DC converter is not specifically limited. For example, the non-isolated DC/DC converter is a boost (Boost) converter, a buck (Buck) converter, or a buck-boost (BuckBoost) converter.

To reduce a loss caused by an inductor, the inductor is no longer disposed; instead, only a magnetic material is disposed inside the PCB, so that a loop between the magnetic material and another device forms a magnetic circuit, to provide a magnetic flux, form a distributed inductor, and implement a function of the inductor. The non-isolated DC/DC converter has no independent wire winding; instead, a component is connected to another component through a wire, and conductors are vertically connected, to form a winding, and the magnetic material is disposed inside the PCB, to reduce inductor disposition. Because there is no discrete inductor, power consumption caused by the inductor is reduced, so that efficiency of the entire non-isolated DC/DC converter is improved. In addition, when the power consumption of the inductor is large, the entire circuit board heats up. If no independent inductor is disposed, power consumption is reduced, and a heat dissipation problem is also resolved.

A disposition form of the magnetic material in the PCB is not limited in this application. The following describes several possible implementations in which the magnetic material is entirely embedded into the PCB, the magnetic material is formed by press-fitting a plurality of layers of magnetic PPs, or the magnetic material is formed by press-fitting magnetic thin films. A manufacturing process in which the magnetic material is entirely embedded into the PCB is the simplest.

A manner for disposing the components of the non-isolated DC/DC converter on the PCB is not specifically limited in this application. In a possible implementation, the switching transistor and the capacitor are respectively located on an upper side and a lower side of the PCB. The switching transistor and the capacitor are connected through a vertical conductor to form a path, at least a part of the magnetic material is surrounded by the path to form a loop, and at least the part of the magnetic material provides a magnetic circuit for the loop when a current flows through the loop. The vertical conductor is an electroplating via hole; or the vertical conductor is an embedded copper pillar.

In addition, the switching transistor may be disposed on a surface of the PCB or embedded inside the PCB. In a possible implementation, the switching transistor is surface-mounted on the surface of the PCB, or the switching transistor is embedded inside the PCB.

In a possible implementation, the capacitor is surface-mounted on the surface of the PCB; or the capacitor is attached to a side wall of the PCB, to connect an upper surface of the PCB to a lower surface of the PCB; or the capacitor is embedded inside the PCB.

Compared with that in a case in which the switching transistor and the capacitor each are located on the surface of the PCB, in a case in which the switching transistor and the capacitor are embedded into a PCB substrate, the entire circuit board may be made thinner, and a heat dissipation path of the component is shorter. Therefore, heat dissipation is better.

In a possible implementation, the switching transistor and the capacitor are located on a same surface of the PCB, or the switching transistor and the capacitor are respectively located on an upper surface and a lower surface of the PCB; and
the switching transistor and the capacitor each form a system-in-a-package SIP module, the PCB and the magnetic material form an integral plate, and the SIP module is combined with the integral plate, to achieve higher integration.

A direction formed between a magnetic flux formed by the magnetic material and a plane on which the PCB is located is not specifically limited in this application. A magnetic flux in the magnetic circuit provided by the magnetic material flows in a closed loop parallel to a horizontal plane on which the PCB is located. Alternatively, a magnetic flux in the magnetic circuit provided by the magnetic material flows in a closed loop vertical to a horizontal plane on which the PCB is located.

In the following, an example in which the non-isolated DC/DC converter is a buck converter is used for description. Switching transistors include a first switching transistor and a second switching transistor. Capacitors include an input capacitor and an output capacitor. The input capacitor, the first switching transistor, and the second switching transistor are disposed on a first surface of the PCB; and the output capacitor is disposed on a surface, other than the first surface, of the PCB.

In a possible implementation, connections of charging and discharging loops of the buck converter include a horizontal connection between the input capacitor, the first switching transistor, the second switching transistor, and the output capacitor, and a vertical connection between the vertical conductors.

A quantity of DC/DC circuits included in the non-isolated DC/DC converter provided in this application is not limited, and there may be one or more DC/DC circuits. For an application requirement, the non-isolated DC/DC converter may include a plurality of DC/DC circuits. Specifically, the non-isolated DC/DC converter is a multiphase coupled buck converter.

The buck circuit is still used as an example. One non-isolated DC/DC converter may include a plurality of buck circuits, and magnetic materials of the plurality of buck circuits are coupled together. When an inductor exists in the buck circuit, inductor windings in the plurality of buck circuits may share a magnet, that is, share a magnetic core. The non-isolated DC/DC converter provided in this application does not include an inductor winding. Therefore, magnetic materials of a plurality of buck circuits may be coupled together. The following specifically describes implementations. Due to inductive coupling between the plurality of buck circuits, magnetic fluxes in the plurality of buck circuits may offset each other. This is equivalent to the following: A total inductance becomes lower. Therefore, a ripple current can be further reduced, so that a loss is further reduced. Because no independent inductor winding is disposed in the non-isolated DC/DC converter provided in this application, power density can be improved. In addition, this is equivalent to the following: A path of a winding is greatly shortened. Therefore, a copper loss of the winding is also reduced.

This application provides a power supply, including the non-isolated DC/DC converter described above, and further including a rectifier circuit. A first terminal of the rectifier circuit is configured to connect to an alternating current power supply; the rectifier circuit is configured to convert an alternating current of the alternating current power supply into a direct current; a second terminal of the rectifier circuit is configured to connect to a first terminal of the non-isolated DC/DC converter; a second terminal of the non-isolated DC/DC converter is configured to supply power to a load; and the non-isolated DC/DC converter is configured to: after converting the direct current, provide an obtained current to the load.

This application further provides a communication device, including the power supply described above. The power supply is configured to supply power to a load in a communication device. The power supply may provide voltages such as 12 V, 5 V, 3.3 V, and 1.0 V for the load in the communication device. A type of the communication device is not specifically limited in embodiments of this application. For example, the communication device is a device in a data center, a server, a base station, or the like.

This application has at least the following advantages:
The non-isolated DC/DC converter provided in this application includes a magnetic material, a switching transistor, and a capacitor. The switching transistor and the capacitor form a charging and discharging loop of the non-isolated DC/DC converter; the magnetic material is located inside a printed circuit board PCB of the non-isolated DC/DC converter; the magnetic material is located in the charging and discharging loop of the non-isolated DC/DC converter, that is, the magnetic material is located in both a charging loop and a discharging loop, to equivalently form a distributed inductor; and a magnetic core material provides a magnetic circuit for the charging and discharging loop of the non-isolated DC/DC converter. To reduce a loss caused by an inductor, a discrete inductor is no longer disposed in the non-isolated DC/DC converter provided in this application; instead, only a magnetic material is disposed inside the PCB, so that a loop between the magnetic material and another device forms a magnetic circuit, to provide a magnetic flux, and implement a function of the inductor. In this way, inductor disposition can be reduced. Because there is no discrete inductor, power consumption caused by the inductor can be reduced, so that efficiency of the entire non-isolated DC/DC converter can be improved.

### BRIEF DESCRIPTION OF DRAWINGS

FIG. 1 is a diagram of a power supply according to an embodiment of this application;
FIG. 2 is a diagram of a charging loop of a buck circuit according to an embodiment of this application;
FIG. 3 is a diagram of a discharging loop of a buck circuit according to an embodiment of this application;
FIG. 4 is a diagram of a non-isolated DC/DC converter according to an embodiment of this application;
FIG. 5 is a diagram of a charging loop corresponding to FIG. 4;
FIG. 6 is a diagram of a discharging loop corresponding to FIG. 4;
FIG. 7 is a diagram of a magnetic material in a PCB according to an embodiment of this application;
FIG. 8 is another diagram of a magnetic material in a PCB according to an embodiment of this application;
FIG. 9 is still another diagram of a magnetic material in a PCB according to an embodiment of this application;
FIG. 10 is a diagram of a horizontal magnetic flux direction in a non-isolated DC/DC converter according to an embodiment of this application;
FIG. 11 is a diagram of a horizontal magnetic flux direction in another non-isolated DC/DC converter according to an embodiment of this application;
FIG. 12 is a diagram of a vertical magnetic flux direction in a non-isolated DC/DC converter according to an embodiment of this application;
FIG. 13 is a diagram of a vertical magnetic flux direction in another non-isolated DC/DC converter according to an embodiment of this application;
FIG. 14 is a three-dimensional diagram of a non-isolated DC/DC converter according to an embodiment of this application;
FIG. 15 is a diagram of a multiphase coupled buck circuit according to an embodiment of this application;
FIG. 16 is a diagram of a PCB of a multiphase buck circuit according to an embodiment of this application;
FIG. 17 is a diagram of a power supply according to an embodiment of this application; and
FIG. 18 is a diagram of a communication device according to an embodiment of this application.

### DESCRIPTION OF EMBODIMENTS

To enable a person skilled in the art to better understand technical solutions provided in embodiments of this application, the following first describes an application scenario of a non-isolated DC/DC converter.

Compared with an isolated DC/DC converter, the non-isolated DC/DC converter has no transformer. Therefore, the non-isolated DC/DC converter has a small size and low costs, and is applicable to supplying power to a last-level load, for example, supplying power to a chip. A specific scenario of the chip is not limited. For example, the chip may be a chip of a network device, or may be a chip of an IT device. Specifically, for example, the non-isolated DC/DC converter supplies power to a chip of a server.

The following describes an application scenario of the non-isolated DC/DC converter with reference to the accompanying drawings.

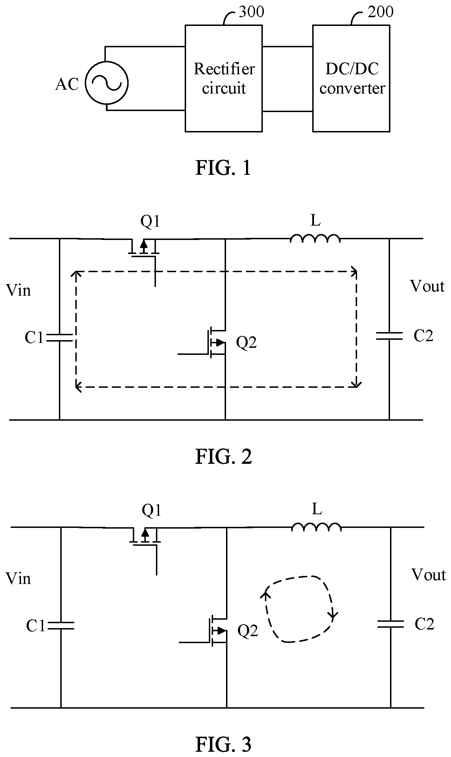

FIG. 1 is a diagram of a power supply according to an embodiment of this application.

The power supply provided in this embodiment includes a non-isolated DC/DC converter 200, and further includes a rectifier circuit 300.

A first terminal of the rectifier circuit 300 is configured to connect to an alternating current power supply AC. The rectifier circuit 300 is configured to convert an alternating current of the alternating current power supply AC into a direct current.

A second terminal of the rectifier circuit 300 is configured to connect to a first terminal of the non-isolated DC/DC converter 200, and a second terminal of the non-isolated DC/DC converter 200 is configured to supply power to a load.

The non-isolated DC/DC converter 200 is configured to: after converting the direct current, provide an obtained current to the load.

The load may be any power-consuming device. Specifically, the non-isolated DC/DC converter 200 may output different voltages based on different loads, for example, may output voltages such as 12 V, 5 V, 3.3 V, and 1.0 V.

In board-level power supply, a requirement for power density is increasingly high. Therefore, a last-level power supply needs to have a small size, low power consumption, and high power supply efficiency. The non-isolated DC/DC converter includes a switching transistor, and implements electric energy conversion by controlling a switching action of the switching transistor. Generally, a switching frequency may be increased to reduce a size of a power supply. However, a higher switching frequency indicates a larger corresponding loss and lower efficiency. To reduce power consumption caused by an inductor in the non-isolated DC/DC converter, a length of the inductor may be reduced. Generally, the inductor is implemented by using a winding, that is, a length of the winding is reduced. However, a shortest winding can only be set to one turn of winding, and cannot be shorter.

### Converter embodiments

To reduce power consumption of an inductor, no discrete inductor is disposed in the non-isolated DC/DC converter provided in embodiments of this application, and only a magnetic material is disposed in a PCB. When a loop formed by a current surrounds the magnetic material, a magnetic circuit is formed, and a magnetic flux passes through the magnetic material, so that a function of the inductor is implemented. In this way, no discrete inductor needs to be disposed on the PCB, so that the power consumption of the inductor can be reduced, and electric energy conversion efficiency of the non-isolated DC/DC converter can be improved.

To enable a person skilled in the art to better understand the non-isolated DC/DC converter provided in embodiments of this application, the following provides detailed descriptions with reference to the accompanying drawings.

For ease of description, the non-isolated DC/DC converter provided in embodiments of this application is referred to as a converter below for short. A specific type of the converter is not specifically limited in embodiments of this application. For example, the converter may be a boost (Boost) converter, or may be a buck (Buck) converter, or may be a buck-boost (BuckBoost) converter, or the like.

To help a person skilled in the art understand the technical solutions provided in embodiments of this application, in the following embodiments, a buck converter, namely, a buck circuit, is used as an example for description. A working principle of the buck circuit is first described with reference to the accompanying drawings.

FIG. 2 is a diagram of a charging loop of a buck circuit according to an embodiment of this application.

The buck circuit includes an input capacitor C1, an output capacitor C2, a first switching transistor Q1, and a second switching transistor Q2.

Two terminals of the input capacitor C1 are connected to two terminals of the input power supply, a first terminal of the first switching transistor Q1 is connected to a first terminal of the input capacitor C1, a second terminal of the first switching transistor Q1 is connected to a first terminal of the second switching transistor Q2, a second terminal of the second switching transistor Q2 is connected to a second terminal of the input capacitor C1, a first terminal of an inductor L is connected to the second terminal of the first switching transistor Q1, a second terminal of the inductor L is connected to a first terminal of the output capacitor C2, and a second terminal of the output capacitor C2 is connected to the second terminal of the input capacitor C1.

The first switching transistor Q1 serves as a main power transistor to perform a switching action, that is, when the first switching transistor Q1 is turned on, an input voltage Vin charges the inductor L. As shown in the charging loop shown by dashed lines in FIG. 2, a current path is: Q1-L-C2-C1. The second switching transistor Q2 acts as a diode to perform a freewheeling function.

FIG. 3 is a diagram of a discharging loop of a buck circuit according to an embodiment of this application.

When the first switching transistor Q1 is turned off, the inductor L discharges, the discharging loop is shown by dashed lines in FIG. 3, and a current path is: L-C2-Q2-L.

The buck circuit corresponding to FIG. 2 and FIG. 3 includes the inductor L, the inductor L is generally disposed on a plane of a PCB, and a size of the inductor is large. Consequently, a size of the PCB is large. In addition, a loss of the inductor is large, and consequently, electric energy conversion efficiency of the entire buck circuit is low.

To reduce a loss caused by an inductor, an inductor is no longer disposed in the non-isolated DC/DC converter provided in embodiments of this application; instead, only a magnetic material is disposed inside the PCB, so that a loop between the magnetic material and another component forms a magnetic circuit, to provide a magnetic flux, form a distributed inductor, and implement a function of the inductor. The non-isolated DC/DC converter provided in embodiments of this application has no independent wire winding; instead, a component is connected to another component through a wire, and conductors are vertically connected, to form a winding, and the magnetic material is disposed inside the PCB. In this way, inductor disposition can be removed. Because there is no discrete inductor, power consumption caused by the inductor can be reduced, so that efficiency of the entire non-isolated DC/DC converter can be improved. In addition, when the power consumption of the inductor is large, the entire circuit board heats up. However, no independent inductor is disposed in embodiments of this application. Therefore, power consumption is reduced, and a heat dissipation problem is also resolved.

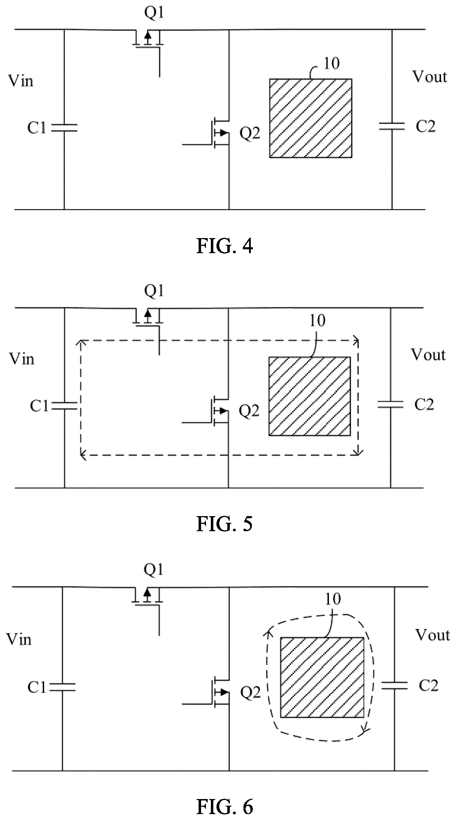

FIG. 4 is a diagram of a non-isolated DC/DC converter according to an embodiment of this application.

The non-isolated DC/DC converter provided in this embodiment of this application includes a magnetic material, a switching transistor, and a capacitor, where
the switching transistor and the capacitor form a charging and discharging loop of the non-isolated DC/DC converter;
the magnetic material is located inside a printed circuit board PCB of the non-isolated DC/DC converter;
the magnetic material is located in the charging and discharging loop of the non-isolated DC/DC converter; and
the magnetic material provides a magnetic circuit for the charging and discharging loop of the non-isolated DC/DC converter.

A specific type of the DC/DC converter is not specifically limited in this embodiment. For better comparison between FIG. 2 and FIG. 3, the following still uses the buck circuit as an example for description.

As shown in FIG. 4, there is no inductor in the buck circuit, and only a magnetic material 10 is disposed. The magnetic material 10 is located in both a charging loop of the buck circuit and a discharging loop of the buck circuit, that is, the magnetic material 10 acts as the inductor. Due to a magnetic conductivity characteristic of the magnetic material 10, when a current forms a closed loop around the magnetic material 10, a magnetic flux passes through the magnetic material 10, and further, a magnetic field is generated.

As shown in a charging loop shown in FIG. 5 and a discharging loop shown in FIG. 6, the magnetic material 10 provided in this embodiment is located in both the charging loop of the buck circuit shown in FIG. 5 and the discharging loop of the buck circuit shown in FIG. 6.

A specific form of the magnetic material inside the PCB is not specifically limited in embodiments of this application. The following lists several implementations by using examples with reference to the accompanying drawings.

The switching transistor is surface-mounted on a surface of the PCB; or the switching transistor is embedded inside the PCB.

The capacitor is surface-mounted on the surface of the PCB; or the capacitor is attached to a side wall of the PCB, to connect an upper surface of the PCB to a lower surface of the PCB.

In addition, both the switching transistor and the capacitor are located on a same surface of the PCB, for example, jointly located on the upper surface of the PCB, or jointly located on the lower surface of the PCB. Alternatively, the switching transistor and the capacitor are respectively located on different surfaces of the PCB. For example, the switching transistor and the capacitor are respectively located on the upper surface and the lower surface of the PCB. The switching transistor and the capacitor each form a system-in-a-package (SIP, System In a Package) module, the PCB and the magnetic material form an integral plate, and the SIP module is combined with the integral plate.

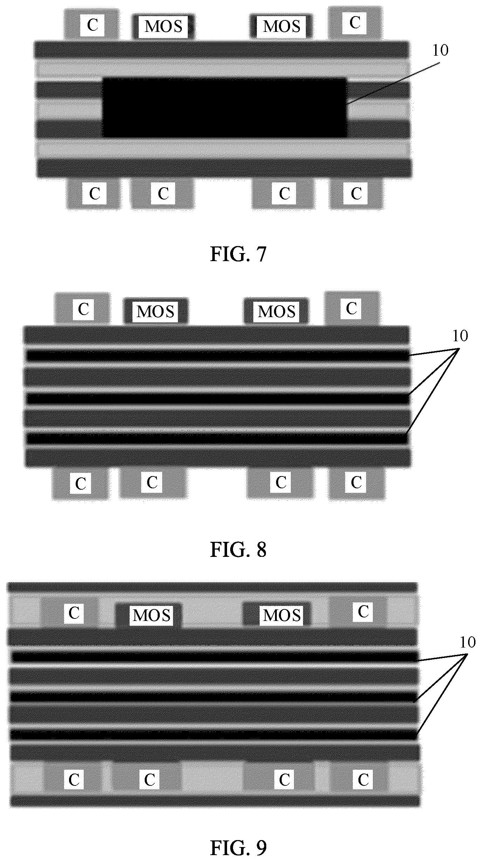

FIG. 7 is a diagram of a magnetic material in a PCB according to an embodiment of this application.

A magnetic material 10 is entirely embedded into the PCB.

Components in the buck circuit may be separately disposed on an upper surface and a lower surface of the PCB. For example, C1, Q1, and Q2 in FIG. 4 are disposed on the upper surface of the PCB, and C2 in FIG. 4 is disposed on the lower surface of the PCB.

As shown in FIG. 7, the magnetic material 10 is entirely embedded into the PCB. A manufacturing process is simple, and the entire magnetic material 10 may be directly embedded into the PCB.

FIG. 8 is another diagram of a magnetic material in a PCB according to an embodiment of this application.

The magnetic material 10 in FIG. 8 is formed by press-fitting a plurality of layers of magnetic PPs. FIG. 8 shows only an example in which three layers of magnetic PPs are press-fitted on the PCB.

In addition, the magnetic material in the non-isolated DC/DC converter provided in embodiments of this application may alternatively be formed by press-fitting magnetic thin films.

In FIG. 7 and FIG. 8, both the capacitor and the switching transistor are located on a surface of the PCB, and the capacitor and the switching transistor may alternatively be located inside the PCB, that is, embedded as dies into the PCB. The following provides detailed descriptions with reference to the accompanying drawings.

FIG. 9 is still another diagram of a magnetic material in a PCB according to an embodiment of this application.

The switching transistor and the capacitor shown in FIG. 9 are embedded into a PCB substrate. Compared with that in a case in which the switching transistor and the capacitor each are located on the surface of the PCB, in an embedded component shown in FIG. 9, the entire circuit board may be made thinner, and a heat dissipation path of the component is shorter. Therefore, heat dissipation is better.

A specific type of the switching transistor is not specifically limited in embodiments of this application. For example, the switching transistor may be any type of a semiconductor switching component. In figures in embodiments of this application, a metal-oxide-semiconductor field-effect transistor (MOS, Metal-Oxide-Semiconductor Field-Effect Transistor) transistor is used as an example for description.

Because the switching transistor and the capacitor are respectively located on different surfaces of the PCB board, the switching transistor and the capacitor need to be electrically connected, to form a closed loop between the switching transistor and the capacitor. The following describes a specific connection manner.

The switching transistor and the capacitor are respectively located on an upper side and a lower side of the PCB. The switching transistor and the capacitor are connected through a vertical conductor to form a path, at least a part of the magnetic material is surrounded by the path to form a loop, and at least the part of the magnetic material provides a magnetic circuit for the loop when a current flows through the loop, to achieve a function of an inductor. For example, to save a material and facilitate processing, the switching transistor and the capacitor may be electrically connected through a vertical conductor.

The vertical conductor may be in a form of electroplating via hole, or in a form of embedded copper pillar. Alternatively, the vertical conductor may be vertically interconnected conductors formed by using another process, that is, the switching transistor is electrically connected to the capacitor. For ease of understanding, in the following embodiments, an example in which the vertical conductor is a via hole is used for description.

A direction of the magnetic flux in the magnetic material is not specifically limited in embodiments of this application. The following describes two different implementations with reference to the accompanying drawings.

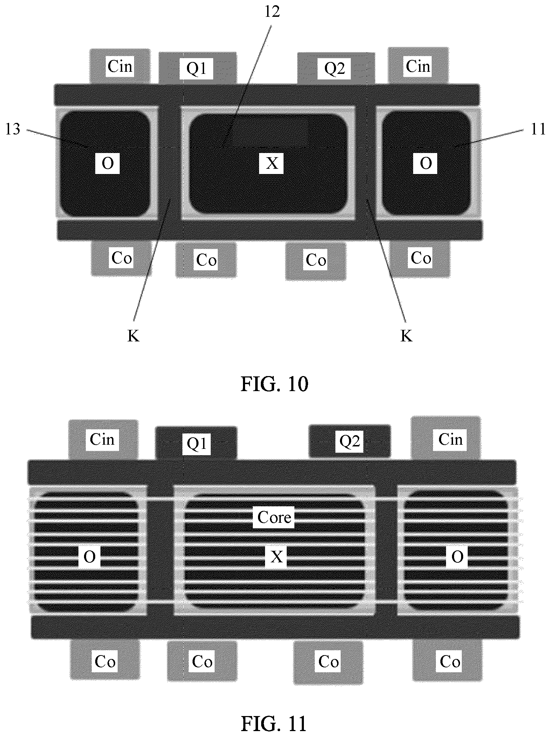

First, a first type of implementation is described. In the non-isolated DC/DC converter provided in embodiments, a magnetic flux in the magnetic circuit provided by the magnetic material flows in a closed loop parallel to a horizontal plane on which the PCB is located. It should be noted that, starting from FIG. 10, an input capacitor is represented by Cin, and an output capacitor is represented by Co.

FIG. 10 is a diagram of a horizontal magnetic flux direction in a non-isolated DC/DC converter according to an embodiment of this application.

In FIG. 10, the buck circuit is still used as an example, where the first switching transistor Q1, the second switching transistor Q2, and input capacitors Cin are surface-mounted on the upper surface of the PCB, and output capacitors Co are surface-mounted on the lower surface of the PCB. A specific side surface that is of the PCB and on which the output capacitor is located is not specifically limited in this embodiment of this application, provided that the output capacitor and another component are not on a same surface. The first switching transistor Q1, the second switching transistor Q2, and the input capacitors Cin are located on a first surface of the PCB, and the output capacitors Co are located on a surface, other than the first surface, of the PCB.

The first switching transistor Q1, the second switching transistor Q2, and the input capacitors Cin on the upper surface of the PCB are electrically connected to the output capacitors Co on the lower surface of the PCB. This may be implemented through via holes K. FIG. 10 shows two via holes K. The via holes K are conductive, and the PCB includes conductive layers. Therefore, the two via holes K and the upper and lower conductive layers form a closed loop. A magnetic material shown in FIG. 10 is divided into a plurality of regions by the closed loop in a horizontal direction of the PCB. In the figure, an example in which the magnetic material is divided into three regions is used.

For example, a current direction of the closed loop is a clockwise direction. According to the right-hand rule, a magnetic flux of a magnetic material 12 located in the middle is in an inward direction, and X is used to represent the inward magnetic flux direction. The inward magnetic flux comes outward from magnetic fluxes of a magnetic material 11 and a magnetic material 13 that are located on two sides, and O is used to represent an outward magnetic flux direction. In this way, a closed magnetic circuit is formed.

Apparently, a layout of the magnetic material and the conductive via holes shown in FIG. 10 enables the magnetic flux direction of the magnetic material in the PCB of the buck circuit to flow in the closed loop in a direction that is parallel to the horizontal plane on which the PCB is located.

Because the magnetic material is sleeved inside the closed loop, and may be equivalent to a function of an inductor, for ease of understanding, it may be considered that one turn of inductor is formed in the closed loop in FIG. 10.

A direction of a magnetic circuit in FIG. 11 is the same as that in FIG. 10, and details are not described herein again. A difference between FIG. 11 and FIG. 10 lies only in a manner for disposing a magnetic material in a PCB. In FIG. 10, the magnetic material is entirely embedded inside the PCB. In FIG. 11, the magnetic material is formed by press-fitting a plurality of layers of magnetic PPs.

The following describes a second type of implementation. In the non-isolated DC/DC converter provided in embodiments, a magnetic flux in the magnetic circuit provided by the magnetic material flows in a closed loop vertical to a horizontal plane on which the PCB is located.

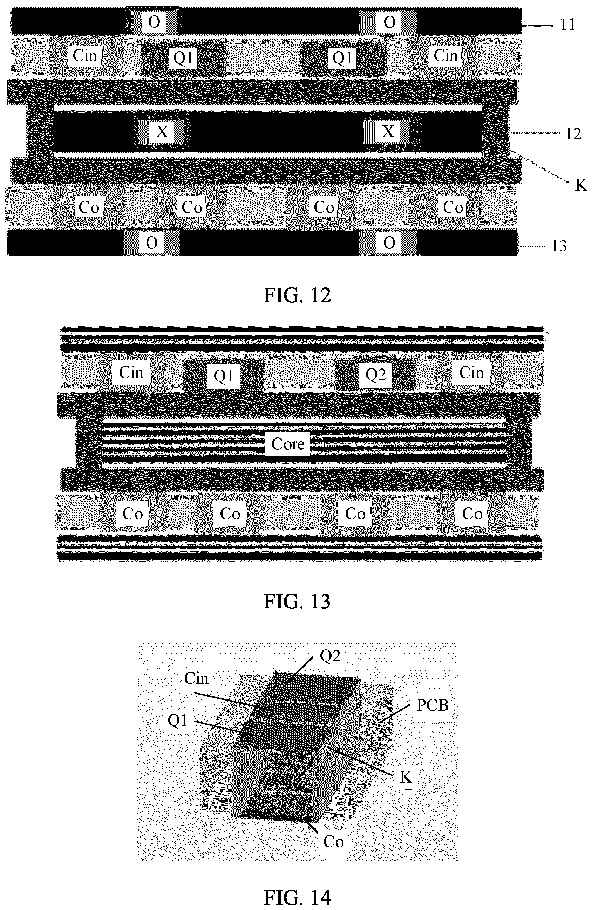

FIG. 12 is a diagram of a vertical magnetic flux direction in a non-isolated DC/DC converter according to an embodiment of this application.

In FIG. 12, the buck circuit is still used as an example. A difference between FIG. 12 and FIG. 10 lies in the following: The components in FIG. 10 and FIG. 11 are located on the upper surface and the lower surface of the PCB, and the components in FIG. 12 are located inside the PCB, that is, embedded inside the PCB. However, the first switching transistor Q1, the second switching transistor Q2, and the input capacitors Cin are located on an upper side of the PCB, and the output capacitors Co are located on a lower side of the PCB.

The first switching transistor Q1, the second switching transistor Q2, and the input capacitors Cin are electrically connected to the output capacitors Co. This may be implemented through via holes K. FIG. 12 shows two via holes K. The via holes K are conductive, and the PCB includes conductive layers. Therefore, the two via holes K and the upper and lower conductive layers form a closed loop. A magnetic material 10 in FIG. 12 is divided into a plurality of regions by the closed loop in a vertical direction of the PCB. In FIG. 12, an example in which the magnetic material is divided into three regions is used.

For example, a current direction of the closed loop is a clockwise direction. According to the right-hand rule, a magnetic flux of a magnetic material 12 located in the middle is in an inward direction, and X is used to represent the inward magnetic flux direction. The inward magnetic flux comes outward from magnetic fluxes of a magnetic material 11 and a magnetic material 13 that are located on an upper side and a lower side, and O is used to represent an outward magnetic flux direction. In this way, a closed magnetic circuit is formed.

Apparently, a layout of the magnetic material and the conductive via holes shown in FIG. 12 enables the magnetic flux of the magnetic material in the PCB of the buck circuit to flow in the closed loop in a direction that is vertical to the horizontal plane on which the PCB is located.

A direction of a magnetic circuit in FIG. 13 is the same as that in FIG. 12, and details are not described herein again. A difference between FIG. 13 and FIG. 12 lies only in a manner for disposing a magnetic material in a PCB. In FIG. 12, the magnetic material is entirely embedded inside the PCB. In FIG. 13, the magnetic material is formed by press-fitting a plurality of layers of magnetic PPs.

The components of the buck circuit in FIG. 12 and FIG. 13 are described by using an example in which the components are embedded inside the PCB. It should be understood that, for the closed loop whose magnetic flux direction is vertical to the horizontal plane on which the PCB is located, the components of the buck circuit may alternatively be disposed in a manner similar to that shown in FIG. 10, that is, disposed on the upper surface and the lower surface of the PCB. Positions of the components of the buck circuit are not specifically limited in embodiments of this application.

Parameters of the buck circuit provided in embodiments of this application are described below with reference to FIG. 10 to FIG. 13, as shown in Table 1.

| Parameter | Value | Unit |
|---|---|---|
| Vin | 12 | V |
| Vo | 3 | V |
| Vt | 9 (Ton) | V |
| Don | 0.25 | \ |
| Fs | 20 | MHz |
| N | 1 | \ |
| Delta B | 0.113 | T |
| Ae | 1 | mm^2 |

| | | |
|---|---|---|
| Herein, Vin represents an input voltage of a converter; Vo represents an output voltage of the converter; Vt represents a voltage drop on an inductor; Don represents a rising duty cycle of an inductor current; Fs represents a switching frequency; N represents a quantity of turns of an inductor winding; Delta B represents a change value of density of a magnetic flux in an inductor magnetic circuit; and Ae represents an effective cross-sectional area of the inductor magnetic circuit. | | |

With reference to the accompanying drawings, the following describes a connection manner between a charging loop and a discharging loop in the non-isolated DC/DC converter provided in embodiments of this application.

FIG. 14 is a three-dimensional diagram of a non-isolated DC/DC converter according to an embodiment of this application.

In this embodiment, an example in which the non-isolated DC/DC converter includes the buck circuit is still used for description. The first switching transistor Q1, the second switching transistor Q2, and the input capacitor Cin are all located on the upper surface of the PCB, and the output capacitor Co is located on the lower surface of the PCB.

In this embodiment of this application, no independent inductor is disposed. For a connection between the charging loop and the discharging loop in the buck circuit, a horizontal connection or partial horizontal connection between the charging loop and the discharging loop is implemented through the foregoing component bodies, and only a vertical connection or a small part of horizontal connection may be implemented through a vertical conductor K. The vertical conductor may be a via hole, or may be another conductor, for example, a column, or a conductor implemented by using a process like electroplating or embedding, for an electrical connection.

Because the non-isolated DC/DC converter provided in embodiments of this application does not include an inductor winding, an area of the PCB can be reduced, so that a size of the entire non-isolated DC/DC converter is reduced, and power density of the non-isolated DC/DC converter is improved. Because no independent inductor winding is disposed, power consumption caused by the inductor can be reduced, and electric energy conversion efficiency of the non-isolated DC/DC converter can be improved.

A quantity of DC/DC circuits included in the non-isolated DC/DC converter provided in embodiments of this application is not limited. For example, there may be one or more DC/DC circuits. In all the foregoing embodiments, an example in which the non-isolated DC/DC converter includes one DC/DC circuit is used. It should be understood that, for an application requirement, the non-isolated DC/DC converter may include a plurality of DC/DC circuits.

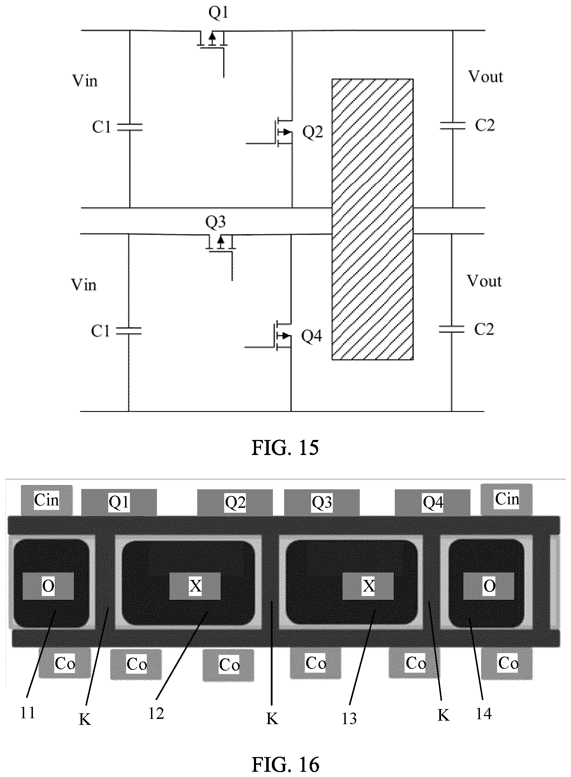

FIG. 15 is a diagram of a multiphase coupled buck circuit according to an embodiment of this application.

The buck circuit is still used as an example. One non-isolated DC/DC converter may include a plurality of buck circuits, and magnetic materials of the plurality of buck circuits are coupled together. When an inductor exists in the buck circuit, inductor windings in the plurality of buck circuits may share a magnet, that is, share a magnetic core. The non-isolated DC/DC converter provided in this embodiment of this application does not include an inductor winding. Therefore, the magnetic materials of the plurality of buck circuits may be coupled together. The following specifically describes implementations.

In FIG. 15, only a two-phase buck circuit is used as an example for description. It is learned from a circuit diagram that the two buck circuits have independent input terminals and output terminals, and only magnetic materials of the two buck circuits may be coupled together.

A first buck circuit includes an input capacitor Cin and an output capacitor Co, and further includes a first switching transistor Q1 and a second switching transistor Q2. A second buck circuit includes an input capacitor Cin and an output capacitor Co, and further includes a third switching transistor Q3 and a fourth switching transistor Q4. For a connection relationship between components in the buck circuit, refer to descriptions corresponding to FIG. 2. Details are not described herein again.

The magnetic materials of the plurality of buck circuits may be entirely embedded into a PCB, or may be formed by press-fitting magnetic films or a plurality of layers of magnetic PPs.

Magnetic fluxes in magnetic circuits provided by the magnetic materials of the plurality of buck circuits flow in a closed loop parallel to a horizontal plane on which the PCB is located. In addition, the magnetic fluxes in the magnetic circuits provided by the magnetic materials of the plurality of buck circuits flow in a closed loop vertical to the horizontal plane on which the PCB is located.

The following describes a PCB layout manner corresponding to FIG. 15 with reference to the accompanying drawings.

FIG. 16 is a diagram of a PCB of a multiphase buck circuit according to an embodiment of this application.

The input capacitor Cin, the first switching transistor Q1, and the second switching transistor Q2 of the first buck circuit, and the input capacitor Cin, the third switching transistor Q3, and the fourth switching transistor Q4 of the second buck circuit are all laid out on an upper surface of the PCB, to facilitate centralized heat dissipation processing. Both the output capacitor Co of the first buck circuit and the output capacitor Co of the second buck circuit are laid out on a lower surface of the PCB. A circuit on the upper surface of the PCB and a circuit on the lower surface of the PCB are electrically connected through via holes.

In FIG. 16, a magnetic flux of a magnetic material flows in a closed loop parallel to a horizontal plane on which the PCB is located, to form a horizontal magnetic circuit.

In FIG. 16, the magnetic material is divided into a plurality of regions, namely, a region 11, a region 12, a region 13, and a region 14, by the via holes in a horizontal direction of the PCB. The first buck circuit and the second buck circuit share the region 12 and the region 13 of the magnetic material.

For the first buck circuit, if a current of a closed loop around the region 12 is in a clockwise direction, according to the right-hand rule, a magnetic flux in the region 12 is in an inward direction, and X is used to represent the inward magnetic flux direction. The inward magnetic flux comes outward from magnetic fluxes in the region 11 and the region 13 that are located on two sides, and O is used to represent an outward magnetic flux direction. In this way, a closed magnetic circuit is formed.

Similarly, for the second buck circuit, if a current of a closed loop around the region 13 is in a clockwise direction, according to the right-hand rule, the magnetic flux in the region 13 is in an inward direction, and X is used to represent the inward magnetic flux direction. The inward magnetic flux comes outward from the magnetic fluxes in the region 12 and the region 14 that are located on two sides, and O is used to represent an outward magnetic flux direction. In this way, a closed magnetic circuit is formed.

The region 12 and the region 13 in FIG. 16 are represented by X because the magnetic fluxes in the region 12 and the region 13 include the inward magnetic flux and the outward magnetic flux. However, the inward magnetic flux is greater than the outward magnetic flux, and therefore, after the inward magnetic flux and the outward magnetic flux offset each other, an overall magnetic flux direction is presented to be inward. Therefore, X is used to represent the flux directions in the region 12 and the region 13.

Due to inductive coupling between the plurality of buck circuits, magnetic fluxes in the plurality of buck circuits may offset each other. This is equivalent to the following: A total inductance becomes lower. Therefore, a ripple current can be further reduced, so that a loss is further reduced.

In addition, when the converter provided in embodiments of this application includes a plurality of buck circuits, for specific design parameters, refer to the foregoing descriptions in Table 1.

Because no independent inductor winding is disposed in the non-isolated DC/DC converter provided in embodiments of this application, power density can be improved. In addition, this is equivalent to the following: A path of a winding is greatly shortened. Therefore, a copper loss of the winding is also reduced.

In addition, in embodiments of this application, a coupling coefficient between the two buck circuits may be adjusted by adjusting mutual positions that are vertically connected in the two buck circuits.

According to the non-isolated DC/DC converter provided in embodiments of this application, a component of a switching loop and a magnetic material partially or completely replace an inductor winding, to break a limitation of a single-turn winding, further reduce a winding loss, and implement a minimum power loop and a minimum parasitic inductor. In this way, space electromagnetic radiation is reduced, signal quality is improved, and a peak voltage of a switching transistor is reduced, so that a filter capacitor and a switching loss are reduced. In addition, no inductor winding is independently disposed on the surface of the PCB, so that a quantity of PCB layers can be reduced, and a height and costs are reduced. In addition, a coupled inductor of the multiphase buck circuit can further reduce a loss of an alternating current impedance ACR of the inductor.

In all the foregoing embodiments of embodiments of this application, the non-isolated DC/DC converter is used as an example to describe an implementation of the inductor, and the magnetic material is used as a replacement. In addition, in addition to that in the non-isolated DC/DC converter, an inductor, namely, a magnetic device, in any other circuit may be replaced with the magnetic material described in the foregoing embodiments. Details are not described herein again.

### Power supply embodiment

Based on the non-isolated DC/DC converter provided in the foregoing embodiments, an embodiment of this application further provides a power supply. The following provides detailed descriptions with reference to the accompanying drawing.

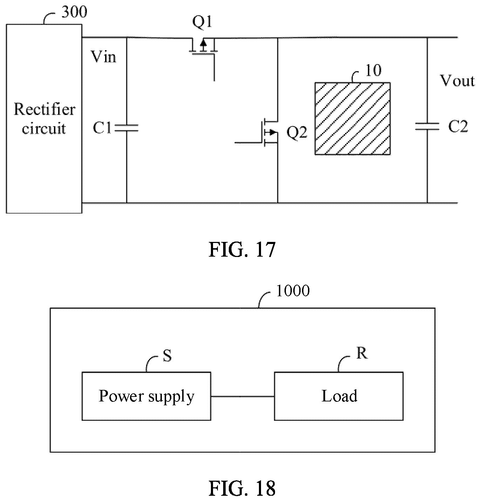

FIG. 17 is a diagram of a power supply according to an embodiment of this application.

The power supply provided in this embodiment of this application includes the non-isolated DC/DC converter described in the foregoing embodiments, and further includes a rectifier circuit 300, where
a first terminal of the rectifier circuit 300 is configured to connect to an alternating current power supply;
the rectifier circuit 300 is configured to convert an alternating current of the alternating current power supply into a direct current; and
a second terminal of the rectifier circuit 300 is configured to connect to a first terminal of the non-isolated DC/DC converter.

A specific implementation form of the non-isolated DC/DC converter is not specifically limited in embodiments of this application. For example, the non-isolated DC/DC converter may be a buck circuit, or may be a boost circuit, or may be a buckboost circuit. In FIG. 17, descriptions are provided merely by using an example in which the non-isolated DC/DC converter is the buck circuit. For example, the buck circuit is configured to: reduce an input 12 V to 3 V and output the 3 V to a load. For specific descriptions of the buck circuit, refer to the descriptions in FIG. 4. Details are not described herein again.

A second terminal of the non-isolated DC/DC converter is configured to supply power to the load; and
the non-isolated DC/DC converter is configured to: after converting the direct current, provide an obtained current to the load.

In addition, the power supply provided in this embodiment of this application may further include one level DC/DC converter, that is, a buck DC/DC converter is included between the rectifier circuit 300 and the non-isolated DC/DC converter in FIG. 17. The buck DC/DC converter is configured to: reduce a direct current voltage output by the rectifier circuit 300 and output a reduced direct current voltage to an input terminal of the non-isolated DC/DC converter.

The power supply provided in this application includes the non-isolated DC/DC converter described in the foregoing embodiments. The non-isolated DC/DC converter includes a magnetic material, a switching transistor, and a capacitor. The switching transistor and the capacitor form a charging and discharging loop of the non-isolated DC/DC converter; the magnetic material is located inside a printed circuit board PCB of the non-isolated DC/DC converter; the magnetic material is located in the charging and discharging loop of the non-isolated DC/DC converter, that is, the magnetic material is located in both a charging loop and a discharging loop, to equivalently form a distributed inductor; and the magnetic core material provides a magnetic circuit for the charging and discharging loop of the non-isolated DC/DC converter. To reduce a loss caused by an inductor, an inductor is no longer disposed in the non-isolated DC/DC converter provided in this application; instead, only a magnetic material is disposed inside the PCB, so that a loop between the magnetic material and another device forms a magnetic circuit, to provide a magnetic flux, and implement a function of the inductor. In this way, inductor disposition can be reduced. Because there is no inductor, power consumption caused by the inductor can be reduced, so that efficiency of the entire non-isolated DC/DC converter can be improved, and efficiency of the power supply is improved.

Based on a power supply provided in the foregoing embodiment, an embodiment of this application further provides a communication device. The power supply is configured to supply power to a load in the communication device. For example, the power supply may provide voltages such as 12 V, 5 V, 3.3 V, and 1.0 V to the load in the communication device. A type of the communication device is not specifically limited in embodiments of this application. For example, the communication device is a device in a data center, a server, a base station, or the like.

Because inductor disposition can be removed in the power supply in the communication device provided in this embodiment of this application, an area and a size of a circuit board are reduced. This facilitates lightness and thinning of the entire communication device, and facilitates heat dissipation of the communication device.

It should be understood that, in this application, "at least one (item)" refers to one or more, and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between associated objects. "At least one of the following items (pieces)" or a similar expression thereof refers to any combination of these items, including a singular item (piece) or any combination of plural items (pieces). For example, at least one of a, b, or c may indicate a, b, c, a and b, a and c, b and c, or a, b, and c, where a, b, and c may be singular or plural.

The foregoing descriptions are merely example embodiments of this application, but are not intended to limit this application in any form. Although the example embodiments of this application are disclosed above, embodiments are not intended to limit this application. By using the method and the technical content disclosed above, any person of ordinary skill in the art can make a plurality of possible changes and modifications on the technical solutions of this application, or amend the technical solutions thereof to be embodiments with equal effects through equivalent variations without departing from the protection scope of the technical solutions of this application. Therefore, any simple amendments, equivalent variations, or modifications made to the foregoing embodiments based on the technical essence of this application without departing from content of technical solutions of this application still fall within the protection scope of the technical solutions of this application.

## Claims

1. A non-isolated DC/DC converter, comprising a magnetic material, a switching transistor, and a capacitor, wherein
the switching transistor and the capacitor form a charging and discharging loop of the non-isolated DC/DC converter;
the magnetic material is located inside a printed circuit board PCB of the non-isolated DC/DC converter;
the magnetic material is located in the charging and discharging loop of the non-isolated DC/DC converter; and
the magnetic material provides a magnetic circuit for the charging and discharging loop of the non-isolated DC/DC converter.

2. The non-isolated DC/DC converter according to claim 1, wherein the magnetic material is entirely embedded into the PCB.

3. The non-isolated DC/DC converter according to claim 1, wherein the magnetic material is formed by press-fitting a plurality of layers of magnetic PPs.

4. The non-isolated DC/DC converter according to claim 1, wherein the magnetic material is formed by press-fitting magnetic thin films.

5. The non-isolated DC/DC converter according to any one of claims 1 to 4, wherein the switching transistor and the capacitor are respectively located on an upper side and a lower side of the PCB; and
the switching transistor and the capacitor are connected through a vertical conductor to form a path, at least a part of the magnetic material is surrounded by the path to form a loop, and at least the part of the magnetic material provides a magnetic circuit for the loop when a current flows through the loop.

6. The non-isolated DC/DC converter according to claim 5, wherein the vertical conductor is an electroplating via hole; or
the vertical conductor is an embedded copper pillar.

7. The non-isolated DC/DC converter according to claim 5, wherein the switching transistor is surface-mounted on a surface of the PCB; or
the switching transistor is embedded inside the PCB.

8. The non-isolated DC/DC converter according to claim 5, wherein the capacitor is surface-mounted on a surface of the PCB; or
the capacitor is attached to a side wall of the PCB, to connect an upper surface of the PCB to a lower surface of the PCB; or
the capacitor is embedded inside the PCB.

9. The non-isolated DC/DC converter according to any one of claims 1 to 4, wherein the switching transistor and the capacitor are located on a same surface of the PCB, or the switching transistor and the capacitor are respectively located on an upper surface and a lower surface of the PCB; and
the switching transistor and the capacitor each form a system-in-a-package SIP module, the PCB and the magnetic material form an integral plate, and the SIP module is combined with the integral plate.

10. The non-isolated DC/DC converter according to any one of claims 1 to 9, wherein a magnetic flux in the magnetic circuit provided by the magnetic material flows in a closed loop parallel to a horizontal plane on which the PCB is located.

11. The non-isolated DC/DC converter according to any one of claims 1 to 9, wherein a magnetic flux in the magnetic circuit provided by the magnetic material flows in a closed loop vertical to a horizontal plane on which the PCB is located.

12. The non-isolated DC/DC converter according to any one of claims 1 to 11, wherein the non-isolated DC/DC converter is a buck converter;
the switching transistor comprises: a first switching transistor and a second switching transistor;
the capacitor comprises an input capacitor and an output capacitor; and
the input capacitor, the first switching transistor, and the second switching transistor are disposed on a first surface of the PCB; and the output capacitor is disposed on a surface, other than the first surface, of the PCB.

13. The non-isolated DC/DC converter according to claim 12, wherein connections of charging and discharging loops of the buck converter comprise a horizontal connection between the input capacitor, the first switching transistor, the second switching transistor, and the output capacitor, and a vertical connection between the vertical conductors.

14. The non-isolated DC/DC converter according to claim 12 or 13, wherein the non-isolated DC/DC converter is a multiphase coupled buck converter.

15. A power supply, comprising the non-isolated DC/DC converter according to any one of claims 1 to 14, and further comprising a rectifier circuit, wherein
a first terminal of the rectifier circuit is configured to connect to an alternating current power supply;
the rectifier circuit is configured to convert an alternating current of the alternating current power supply into a direct current;
a second terminal of the rectifier circuit is configured to connect to a first terminal of the non-isolated DC/DC converter;
a second terminal of the non-isolated DC/DC converter is configured to supply power to a load; and
the non-isolated DC/DC converter is configured to: after converting the direct current, provide an obtained current to the load.

16. A communication device, comprising the power supply according to claim 15, wherein the power supply is configured to supply power to a load in the communication device.
